# EUROPEAN PATENT APPLICATION

(11) **EP 1 271 636 A1**
(43) Date of publication of application: **02.01.2003**
(21) Application number: 01115213.9
(22) Date of filing: 22.06.2001
(51) Int. Cl.: H01L 21/316

(54) **Thermal oxidation process control by controlling oxidation agent partial pressure**

(71) Applicant: Infineon Technologies AG, 81669 München (DE)
(72) Inventor: Tognetti, Marcel, 01109 Dresden (DE)
(74) Representative: Müller - Hoffmann & Partner

(57) **Abstract**

The invention relates to a method for generating an oxide layer on a substrate, e.g. a silicon wafer used for the manufacturing of microchips. The substrate is placed in an oven and an oxidising medium comprising oxygen is fed to the oven. To control the growth of the oxide layer the oxygen partial pressure in the exhaust is determined and depending on the measured value the feed of the components of the oxidising mediums are adjusted, so that the oxygen partial pressure in the oxygen gases is kept constant. The method allows the reproducible formation of oxide layers with a defined layer thickness.

## Description

The invention relates to a method for generating an oxide layer on a substrate, e.g. a silicon wafer.

During the manufacturing of microchips thin layers of metal oxides, e.g. silicon oxides, have to be deposited on the surface of a wafer. For that purpose the wafer is placed in an oven at elevated temperature and an oxidising agent, e.g. molecular oxygen, is supplied to oxidise a metal provided on the surface of the wafer. There are two basic methods to produce an oxide layer on the surface of the wafer. The first type of reaction uses basically gaseous oxygen as an oxidising agent which may be diluted by an inert gas, e.g. nitrogen gas. This type of oxidation process is called "dry oxidation". According to a second oxidation procedure water vapor is used as the oxidising agent in the presence of excess oxygen. This type of oxidation process is called "wet oxidation". Usually a catalyst is added to the oxidising agent, e.g. hydrogen chloride. To obtain reproducible results as to the layer thickness of the oxide layer the oxidation reaction has to be controlled with high precision. Currently several obstacles exist in the production of an oxide layer having a precisely defined layer thickness. The velocity of the reaction is depending on the gas pressure inside the oven which is influenced by the air pressure in the surroundings. When keeping the feed of the oxidising agent to the oven and the oven temperature as well as other reaction parameters constant the layer thickness is therefore influenced by variations in the surrounding air pressure. Furthermore the oxidation reaction is performed at high temperatures of more than 1000°C and therefore the interior of the oven has to be lined with a temperature resistant material, e.g. quartz. Sealing materials withstanding high temperatures and the highly corrosive atmosphere used for the manufacturing of the oxide layer are currently not available. Therefore a problem exists in the leak tightness of the oven door used to place the substrate inside the oven. Usually a leak occurs at the oven door seal and highly corrosive oxidation agent is leaking out of the oven door. To remove this highly corrosive material the outside of the oven door seal is flushed with an inert gas, usually nitrogen gas or is evacuated. Flushing the outside of the door effects that through the door leak also small amounts of the inert gas flow into the oven. The amount of this inert gas leaking into the oven cannot be controlled and is varying depending on variations of the flow of the inert gas. This also effects variations in the layer thickness of the oxide layer on the substrate surface.

To overcome such problems several methods for generating an oxide layer of constant thickness have been proposed but which all did not lead to satisfactory results.

According to a first method the reaction time used for the manufacturing of the oxide layer is varied depending on the air pressure in the surroundings. As there is no linear relationship between pressure, reaction time and layer thickness of the oxide layer the variation of the reaction time depending on the pressure to obtain a constant layer thickness has to be determined empirically. Therefore a high number of experiments have to be performed for each individual oven and the relationship found empirically has permanently to be rechecked to adapt the parameters to variations in the oven equipment, e.g. in the tightness of the oven door.

According to another proposed method the interior pressure of the oven is kept constant by feeding nitrogen gas to the oven and varying the nitrogen feed depending on the surrounding air pressure. Experiments revealed that this method could not provide a constant oxide layer thickness over a longer production period.

It therefore is an object of the invention to provide a method for generating an oxide layer on a substrate wherein the layer thickness can be precisely controlled and oxide layers having a precise layer thickness can be reproducibly obtained over longer production periods.

To solve this problem encountered with such object a method for generating an oxide layer on a substrate is provided wherein the substrate is placed in a reaction chamber equipped with feed means for feeding an oxidising medium to the reaction chamber, control means for controlling the feed of the oxidising medium to the reaction chamber, an exhaust for removing exhaust gases from the reaction chamber, and a sensing element to determine the oxygen partial pressure in the exhaust gases, wherein the oxidising medium comprises molecular oxygen and during the generation of the oxide layer the oxygen partial pressure in the exhaust gases is kept constant.

By controlling the partial pressure of oxygen in the exhaust a precise control of the oxidation reaction conditions is possible and a reproducible formation of oxide layers having a defined layer thickness is made possible. The oxygen partial pressure in the exhaust gases can be kept constant, e.g. by varying the feed of the oxidising medium to the reaction chamber. In a practical implementation of the method a range is defined within the partial pressure of oxygen in the exhaust gases may vary. This range may easily be found by experiments in which the influence of small variations of the oxygen partial pressure in the exhaust gases on the layer thickness of the oxide layer is investigated. The method may easily be automated and therefore a precise manufacturing of oxide layers over longer production periods is made possible. The method compensates variations in the air pressure of the surroundings as well as variations caused by leaks of the reaction chamber.

The method may be performed as a "dry oxidation" as well as a "wet oxidation". In the latter case the oxidising medium further comprises water vapour. The water vapour is usually produced by providing a torch to which hydrogen and oxygen gas is fed. The water is produced by an oxyhydrogen flame. Preferably an excess of oxygen gas is used to avoid the danger of explosions inside the reaction chamber.

To accelerate the oxidation reaction a catalyst may be fed to the reaction chamber. In this case the oxidising medium further comprises a catalyst. Usually acids are used as a catalyst, preferably hydrogen chloride. The catalyst may be fed to the reaction chamber together with the other components of the oxidising medium, e.g. by feeding the catalyst to the torch. In a further embodiment a separate feed for the catalyst may be provided.

To further improve the precision of the formation of an oxide layer having a precise layer thickness a molar ratio of oxygen : water vapour in the feed of the oxidising medium is kept constant. When using a torch for the formation of water vapour then also the amount of hydrogen fed to the torch has to be varied when varying the oxygen amount fed to the torch to keep constant the partial pressure of oxygen in the exhaust gases.

When using a catalyst in the oxidation reaction the molar ratio of oxygen : water vapour : catalyst in the feed of the oxidising medium is preferably kept constant. In this embodiment also the amount of catalyst fed to the reaction chamber has to be adapted when varying the oxygen amount fed to the reaction chamber.

In a preferred embodiment the oxidising medium further comprising an inert gas. As an inert gas may be used e.g. noble gases or preferably nitrogen. When using an inert gas as a component of the oxidising medium the partial pressure of oxygen in the exhaust gases may also be kept constant by controlling the inert gas ratio in the feed of the oxidising medium. The control of the inert gas ratio can be controlled quite easy by varying the feed of the inert gas to the reaction chamber.

The method according to the invention also allows a compensation of leaks of the reaction chamber, e.g. caused by a leak in the seal of a door of the reaction chamber. Such a leak then provides a secondary feed to the reaction chamber and inert gas is fed to the reaction chamber by the secondary feed. The inert gas may be same or different from the inert gas fed to the reaction chamber as a component of the oxidising medium. Preferably nitrogen is used and the secondary feed is caused by flushing the outside door seal of the reaction chamber with nitrogen gas.

To compensate for variations in the secondary feed preferably a minimum ratio of inert gas is provided in the feed of the oxidising agent. In a practical implementation of the method according to the invention a given amount of inert gas enters through a leak at the door seal into the reaction chamber. This amount may vary over the time e.g. due to fluctuations in the flow of the inert gas used to flush the outside of the door. When providing a minimum ratio of inert gas in the feed of the oxidising medium the partial pressure of oxygen in the exhaust gases may be kept constant much easier when the secondary flow entering the reaction chamber through a leak becomes very low.

Preferably the oxide layer is produced by oxidising the substrate material. The substrate preferably is a silicon wafer used in the production of microchips.

The formation of the oxide layer is preferably formed at elevated temperatures. The reaction chamber therefore is preferably formed as an oven.

The partial pressure of oxygen in the exhaust gases is preferably determined by providing a sensing element for determining the total gas pressure within the reaction chamber and a sensing element for determining the oxygen concentration in the exhaust gases and calculating the oxygen partial pressure by multiplying the total pressure within the reaction chamber by the oxygen concentration (0 ≤ C(O₂) ≤ 1) in the exhaust gas.

In the following the invention is explained in more detail with reference to the accompanying figures.
- Fig. 1: shows schematically a device for performing the method according to the invention;
- Fig. 2: shows schematically an enlarged section of the oven shown in fig.1;

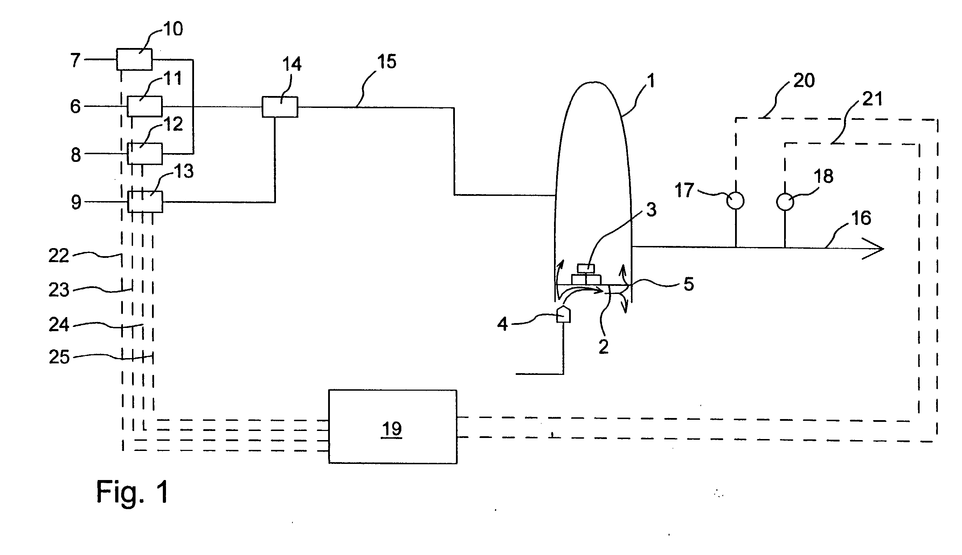

In Fig. 1 an oven 1 is provided with a door 2 which might be opened to place a substrate 3 in the interior of oven 1. The outside seal of door 2 is flushed with nitrogen gas provided by a nitrogen valve 4. Small amounts of nitrogen gas are leaking into the interior of oven 1 through leaks 5 between the oven and the edge of door 2.

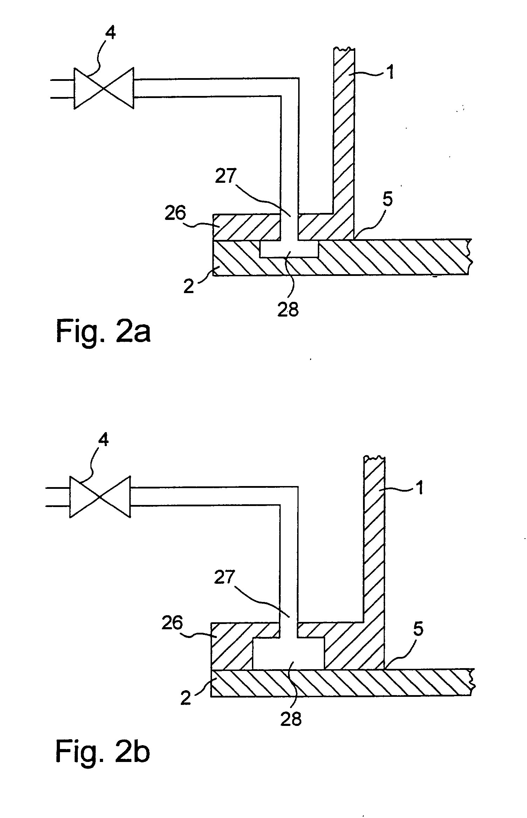

The occurrence of the leak is explained with reference to fig. 2a and 2b. Oven 1 is provided with a flange 26 which has an opening 27. Opening 27 is connected to nitrogen valve 4. The surface of door 2 fits closely to the surface of flange 26. Door 2 is provided with a groove 28, which is extending parallel to the edge of door 2. Nitrogen coming from nitrogen valve 4 is entering groove 28 through opening 27, is then flowing through groove 28 and then leaves groove 28 through a further opening (not shown). Between the surfaces of flange 26 and door 2 a small leak 5 forms. Through leak 5 either reaction gases may flow from the interior of oven 1 towards groove 28 or nitrogen gas may flow from groove 28 towards the interior of oven 1. Groove 28 may also be provided at the oven flange 26 as shown in fig. 2a. The reaction gases entering groove 28 are flushed away by the nitrogen gas flowing in groove 28.

To prepare an oxidising medium four feeds are provided in the device shown in fig. 1, feeding oxygen 6, nitrogen 7, hydrogen chloride 8 and hydrogen 9 to a torch 14.The feed of the gases can be controlled by mass flow controllers 10 - 13, respectively. In torch 14 water vapour is produced by an oxyhydrogen flame. The oxidising medium consisting of nitrogen, hydrogen chloride, water vapour and excess oxygen is then fed to oven 1 by a pipe 15. In the interior of oven 1 the surface of substrate 3 is oxidised by the oxidation medium. The exhaust gases are then removed from the interior of oven 1 by an exhaust 16. In the exhaust is provided a sensor 17 for determining the total pressure inside the oven and a sensor 18 for determining the oxygen concentration in the exhaust gases. Signals corresponding to the total pressure determined by sensor 17 and the oxygen concentration determined by sensor 18 are provided to a computer by wires 20 and 21, respectively. In computer 19 the partial oxygen pressure in the exhaust gases is calculated based on the information provided by sensors 17 and 18. The calculated partial pressure of oxygen is then compared to a set point defined for the oxygen partial pressure and a deviation from the set point is calculated. Depending on the deviation of the oxygen partial pressure in the exhaust gases new set points are calculated for the oxygen, nitrogen, hydrogen chloride and hydrogen feeds 6 - 9, respectively. A signal is then sent to mass flow controllers 10 - 13 by wires 22 - 25 to adjust the feed of the oxygen medium components to the new set points.

## Claims

1. Method for generating an oxygen layer on a substrate wherein the substrate is placed in an reaction chamber equipped with feed means for feeding an oxidising medium to the reaction chamber, control means for controlling the feed of the oxidising medium to the reaction chamber, an exhaust for removing exhaust gases from the reaction chamber, and a sensing element to determine the oxygen partial pressure in the exhaust gases, wherein the oxidising medium comprises molecular oxygen and during the formation of the oxide layer the oxygen partial pressure in the exhaust gases is kept constant.

2. Method according to claim 1, wherein the oxidising medium further comprises water vapour.

3. Method according to claim 1 or 2, wherein the oxidising medium further comprises a catalyst.

4. Method according to one of claims 1 to 3, wherein the molar ratio of oxygen : water vapour in the feed of the oxidising medium is kept constant.

5. Method according to one of the preceding claims, wherein the molar ratio of oxygen : water vapour : catalyst in the feed of the oxidising medium is kept constant.

6. Method according to one of the preceding claims, wherein the oxidising medium further comprises an inert gas.

7. Method according to claim 6, wherein the oxygen partial pressure is kept constant by controlling the inert gas ratio in the feed of the oxidising medium.

8. Method according to one of the preceding claims, wherein a secondary feed is provided in the reaction chamber and inert gas is fed to the reaction chamber by the secondary feed.

9. Method according to one of claims 6 to 8, wherein a minimum ratio of inert gas is provided in the feed of the oxidising agent.

10. Method according to one of the preceding claims, wherein the oxide layer is produced by oxidising the substrate material.

11. Method according to one of the preceding claims, wherein the substrate is a silicon wafer.

12. Method according to one of the preceding claims, wherein the reaction is formed as an oven and the formation of the oxide layer is performed at elevated temperature.

13. Method according to one of the preceding claims, wherein a sensing element for determining the total gas pressure within the reaction chamber and a sensing element for determining the oxygen concentration in the exhaust gas is provided and the oxygen partial pressure is calculated by multiplying the total pressure within the reaction chamber by the oxygen concentration in the exhaust gas.
